# EUROPÄISCHE PATENTSCHRIFT

(11) **EP 2 724 597 B1**
(45) Veröffentlichungstag und Bekanntmachung des Hinweises auf die Patenterteilung: **18.01.2017**
(21) Anmeldenummer: 12737201.9
(22) Anmeldetag: 21.06.2012
(51) Int. Cl.: H05K 3/20, H05K 3/34, H05K 3/00, H01G 2/06

(54) **ELEKTRONISCHE BAUGRUPPE UND VERFAHREN ZU DEREN HERSTELLUNG**
ELECTRONIC ASSEMBLY AND METHOD FOR THE PRODUCTION THEREOF
MODULE ÉLECTRONIQUE ET SON PROCÉDÉ DE FABRICATION

(30) Priorität: 21.06.2011 DE 102011105346
(43) Veröffentlichungstag der Anmeldung: 30.04.2014
(73) Patentinhaber: Schweizer Electronic AG, 78713 Schramberg (DE)
(72) Erfinder: GOTTWALD, Thomas, 78655 Dunningen-Seedorf (DE); RÖSSLE, Christian, 78112 St. Georgen (DE)
(74) Vertreter: Glawe, Delfs, Moll
(86) Internationale Anmeldenummer: PCT/EP2012/002622
(87) Internationale Veröffentlichungsnummer: WO 2012/175207

(56) Entgegenhaltungen:
- EP-A1- 1 788 596
- DE-A1- 19 717 550
- JP-A- 11 089 247
- US-A- 3 978 375
- US-A- 4 295 184
- US-B1- 6 305 972
- US-B1- 6 400 551

## Beschreibung

### Technisches Gebiet

Die vorliegende Erfindung betrifft eine elektronische Baugruppe und ein Verfahren zu deren Herstellung sowie einen Elektromotor, bspw. für ein Kraftfahrzeug.

Elektronische Bauteile bzw. elektronische Baueinheiten oder Baugruppen für die Leistungselektronik sind bspw. in Form von DCB-Modulen (Direct Copper Bonding) bekannt. Dabei handelt es sich meist um Keramik-Substrate mit aufgelöteten Leistungshalbleitern, an die weitere benötigte (passive) Bauelemente angeschlossen werden. Bei diesen Bauelementen kann es sich im Falle von Wechselrichtern/Gleichrichtern um Kondensatoren, insb. Folienkondensatoren sowie Induktivitäten handeln.

Die US 6,305,972 B1 offenbart eine Vorrichtung zum Anbringen einer elektronischen Komponente an eine Leiterplatte, wobei die elektronische Komponente einen positiven und einen negativen Anschluss aufweist. Die bekannte Vorrichtung umfasst jeweils eine positive und eine negative Anschlussplatte mit jeweils einem Komponentenanschluss und einem Leiterplattenanschluss, die von der jeweiligen Anschlussplatte winklig abragen. Zwischen den beiden Anschlussplatten ist eine Isolierschicht vorgesehen.

Die EP 1 788 596 A1 offenbart ein Kondensatormodul mit einer Mehrzahl von Kondensatoren, die auf einem Laminataufbau aus mehreren Laminatschichten angeordnet und mittels von den Laminatschichten winklig abragenden Anschlüssen ankontaktiert sind.

Die DE 19717550 A1 offenbart ein flaches Stromschienenpaket für ein Stromrichtergerät zur Verbindung der Anschlüsse von auf einem Kühlkörper montierten Leistungshalbleitern. Das bekannte Stromschienenpaket besteht aus mindestens zwei gegeneinander elektrisch isolierten Stromschienen. Mindestens ein Kondensator ist direkt auf einer Hauptfläche des Stromschienenpaketes montiert und mit elektrischen Anschlüssen der Stromschienen verbunden.

Das US-Patent 4,295,184 offenbart eine bspw. als Mehrschichtleiterplatte ausgeführte Leiterplatte mit Federkontakten, die einteilig mit der Leiterschicht ausgebildet sind. Die Leiterschicht ist auf einer (durchgehenden) Trägerplatte aufgebondet. Die Kontakte sind innerhalb einer Ausnehmung einer aufgeklebten dielektrischen Deckschicht ausgebildet.

Weiterer Stand der Technik ist in JP 11 089247 A, US 6 400 551 B1 und US 3 978 375 A zu finden.

Ausgehend hiervon werden erfindungsgemäß eine elektronische Baugruppe mit den Merkmalen des Anspruchs 1 und ein Verfahren zu deren Herstellung mit den Merkmalen des Anspruchs 8 sowie
ein Elektromotor mit den Merkmalen des Anspruchs 7 vorgeschlagen.

Die erfindungsgemäße elektronische Baugruppe verfügt über eine Leiterplattenstruktur mit einem Mehrschichtaufbau. Der Mehrschichtaufbau umfasst in an sich bekannter Weise mindestens zwei elektrisch leitende Schichten. Die Erfindung sieht vor, jede dieser zwei Schichten so zu verlängern, dass sie einen über den Mehrschichtaufbau hinausragenden Abschnitt aufweisen, der einen zur direkten Ankontaktierung eines zusätzlichen passiven Bauelements ausgebildeten Anschlussbereich definiert. Diese Anschlussbereiche können bspw. laschenartig oder streifenförmig ausgebildet sein.

Dies ermöglicht eine deutliche Reduktion der bei den bekannten DCB-Modulen mit ihren langen Leitungen und Anschlüssen stark vorhandenen parasitären Induktivitäten. Darüber hinaus werden eine kurze und niederinduktive Anbindung von Leistungshalbleitern in dem Mehrschichtaufbau und eine kompakte Bauweise ermöglicht. Die Anzahl der Verbindungsstellen zwischen aktivem und passivem Bauelement, insbesondere durch Bonden, verringert sich, da nur noch der aus dem Leiterplattenkernbereich herausragende Anschlussbereich mit dem passiven Bauelement verbunden werden muss. Das zusätzliche passive Bauelement kann bspw. ein Kondensator und/oder eine Induktivität und/oder ein Widerstand sein.

Zur Herstellung einer erfindungsgemäßen elektronischen Baugruppe wird ein Mehrschichtaufbau mit einer elektrisch leitenden Trägerschicht und mindestens einer weiteren elektrisch leitenden Schicht bereitgestellt. Die Trägerschicht und die weitere elektrisch leitende Schicht weisen über einen Kernbereich des Mehrschichtaufbaus hinausragende Schichtabschnitte auf. Nicht als Anschlussbereiche benötigte Schichtabschnitte werden zumindest teilweise entfernt, und auch über den Kernbereich hinausragende Prepreg-Schichtabschnitte werden zumindest teilweise entfernt. Falls erforderlich, werden die über den Kernbereich hinausragenden verbliebenen Schichtabschnitte zur Bildung von Anschlussbereichen für ein passives Bauelement gebogen. Dies stellt ein besonders einfaches Herstellen eines kompakten Baugruppe mit integrierten und über den eigentlichen Schichtaufbau hinausragenden Anschlussbereichen für einen direkten niederinduktiven Anschluss eines passiven Bauelements ohne zusätzliche Zwischenstelle dar.

Gemäß einer Variante wird vor den Schritten des teilweisen Entfernens mindestens eine Durchkontaktierung zwischen einem hinausragenden Schichtabschnitt der weiteren elektrisch leitenden Schicht und einem hinausragenden Schichtabschnitt der Trägerschicht hergestellt und der hinausragende Schichtabschnitt der weiteren elektrisch leitenden Schicht wird von der weiteren elektrisch leitenden Schicht abgetrennt. Dadurch wird erreicht, dass beide über den Mehrschichtaufbau hinausragenden Anschlussbereiche auf der gleichen Ebene liegen und die gleiche Dicke aufweisen.

Durch Kombination der über den Mehrschichtaufbau hinausragenden Anschlussbereiche mit induktiven Bauelementen, wie z.B. Ferritkernen, können außerdem gezielt Induktivitäten mit spezifischem Wert erzeugt werden. Diese induktiven Bauelemente können alleine für sich oder auch in Kombination mit anderen passiven Bauelementen, wie einem Kondensator, verwendet werden.

Die Anschlussbereiche können mindestens eine Ausnehmung mit einer darin enthaltenen Kontaktierungsfläche zum Ankontaktieren eines passiven Bauelements aufweisen. Dadurch wird das direkte Verbinden mit dem passiven Bauelement erleichtert. Die Kontaktierungsfläche kann beispielsweise mittels mindestens eines Haltesteges elektrisch mit dem Anschlussbereich verbunden sein. Dadurch findet beim Anlöten/Anschweißen aufgrund des verringerten Querschnitts des Haltestegs ein geringerer Wärmeabtransport statt. Die Kontaktierungsflächen können so bspw. direkt an die Schoopierschicht eines Folienkondensators angelötet werden. Für die Ausgestaltung der Kontaktierungsflächen und auch der Haltestege bieten sich unterschiedliche Geometrien an. Die Haltestege können derart ausgestaltet sein, dass sie unterschiedliche Ausdehnungskoeffizienten beim Betrieb bzw. die damit verbundenen mechanischen Spannungen aufnehmen. Die Haltestege können beispielsweise mäanderförmig/geschlängelt verlaufen, oder durch ihre Anbringungsgeometrie eine Verformung oder Verdrehung zulassen.

Weitere Vorteile und Ausgestaltungen der Erfindung ergeben sich aus der Beschreibung und der beiliegenden Zeichnung.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist zur Veranschaulichung anhand von Ausführungsbeispielen in der Zeichnung stark schematisch und nicht maßstabsgetreu dargestellt und wird im folgenden unter Bezugnahme auf die Zeichnung ausführlich beschrieben.

### Kurzbeschreibung der Zeichnung

Figur 1 zeigt eine seitliche Schnittdarstellung durch ein erstes Ausführungsbeispiel einer elektronischen Baugruppe der Erfindung.
Figur 2 zeigt eine seitliche Schnittdarstellung durch ein zweites Ausführungsbeispiel einer elektronischen Baugruppe der Erfindung.
Figuren 3 bis 6 veranschaulichen die Herstellung der erfindungsgemäßen Anschlussbereiche.
Figur 7 zeigt einen Mehrschichtaufbau mit Trennschichten zur Verwendung bei der Herstellung der erfindungsgemäßen Anschlussbereiche.
Figuren 8 bis 12 veranschaulichen eine alternative Herstellung der erfindungsgemäßen Anschlussbereiche.
Figur 13 zeigt in Draufsicht eine Ausgestaltung eines erfindungsgemäßen Anschlussbereichs.

### Ausführliche Beschreibung

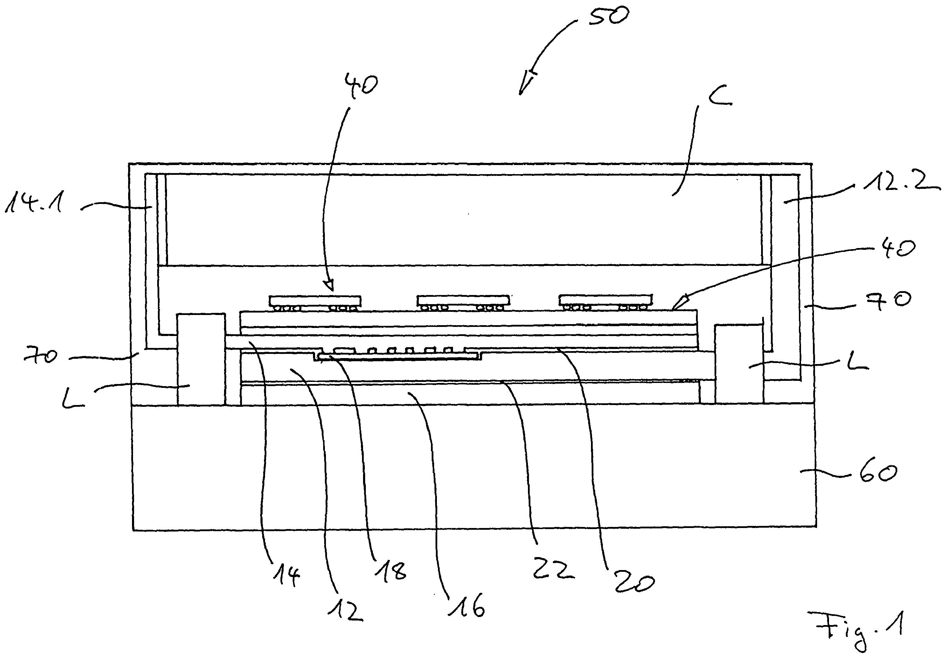

Figur 1 zeigt eine erfindungsgemäße elektronische Baugruppe 50 in seitlicher Schnittdarstellung.

Die Baugruppe 50 umfasst einen Leiterplattenmehrschichtaufbau, der eine Trägerschicht 12 aufweist, die ein (eingebettetes) Halbleiterbauelement 18 trägt. Oberhalb der Trägerschicht 12 und des Halbleiterbauelements 18 erstreckt sich eine Prepreg-Schicht bzw. eine aus einer früheren Prepreg-Schicht hervorgegangene Harzschicht 20, über der eine weitere elektrisch leitende Schicht 14 liegt. Diese weist Durchkontaktierungen zu dem Halbleiterbauelement 18 auf. Auf der oberen Schicht 14 kann - wie dargestellt - eine Logikschaltung 40 aufgebracht sein, bspw. durch Auflaminieren. Bei dem dargestellten Ausführungsbeispiel einer elektronischen Baugruppe handelt es sich um ein Gleichrichter-/Wechselrichtersystem in Brückenanordnung und die zugehörige Logik-Ansteuerung. Die dargestellte Logikschaltung kann allerdings auch als separate Schaltung vorliegen und mit gängiger Verbindungstechnik an den leistungselektronischen Teil angekoppelt sein.

Unterhalb der Trägerschicht ist - getrennt durch eine zweite Prepreg-Schicht 22 - eine zweite weitere elektrisch leitende Schicht 16 vorgesehen. Diese ist elektrisch isolierend von der Schicht 12 angeordnet, jedoch in ihrer Materialdicke und ihren Materialeigenschaften so gewählt, dass eine gute thermische Leitfähigkeit und gleichzeitig eine hohe Durchschlagsfestigkeit erzielt wird. Die Anordnung ist mit der zweiten weiteren Schicht 16 auf einer Kühlsenke 60 angeordnet.

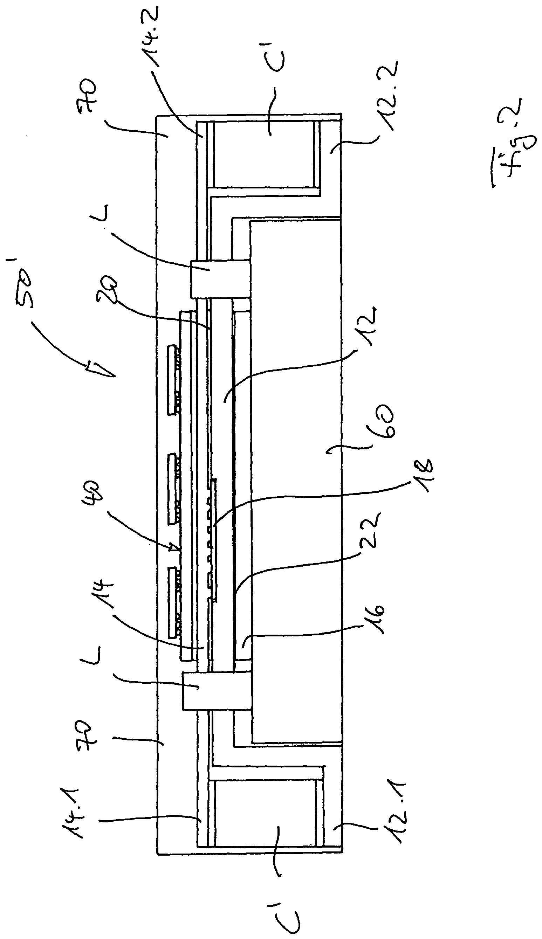

Die Verbindung mit der Kühlsenke 60 kann direkt werkseitig erfolgen, so dass die erfindungsgemäße Baugruppe bereits vollständig mit einem Kühlelement ausgeliefert wird. Dies könnte sich beispielsweise bei der in Figur 2 dargestellten kompakten Bauweise mit einem den Mehrschichtaufbau einschließlich der Kühlsenke umgebenden Ringkondensator anbieten. Andererseits kann die Baugruppe auch erst am Bestimmungsort mit einem dort eventuell bereits vorhandenen und als Kühlsenke dienenden Element verbunden werden. Hierzu kann die Unterseite der Baugruppe (d.h. die Unterseite der zweiten leitenden Schicht 16) eine (nicht dargestellte) Haftpastenschicht o. dgl. mit ausreichender thermischer Leitfähigkeit aufweisen (vgl. das nachfolgend beschrieben Beispiel eines Kfz-Elektromotors in Absatz [0024]).

Die Trägerschicht 12 ist - in der Darstellung der Figur 1 nach rechts - über den eigentlichen Mehrschichtaufbau hinaus verlängert und bildet einen Anschlussbereich 12.2. In analoger Weise ist die weitere leitende Schicht 14 in gegenüberliegender Richtung über den "Kernbereich" oder "Funktionsbereich" des Mehrschichtaufbaus hinaus verlängert, um einen Anschlussbereich 14.1 zu bilden. Im dargestellten Ausführungsbeispiel handelt es sich bei den Anschlussbereichen 12.2 und 14.1 um Anschlüsse für einen Kondensator C, die somit direkt mit den Drain- bzw. Source-Anschlüssen der Leistungshalbleiter verbunden sind.

Erfindungsgemäß werden auf diese Art und Weise Anschlussbereiche 12.2, 14.1 direkt aus dem Leiterplattenmehrschichtaufbau herausgeführt und direkt mit einem passiven Bauelement, wie im vorliegenden Fall einem Kondensator, verbunden. Dadurch wird eine kurze Anbindung des passiven Bauelements an das Halbleiterbauelement 18 erreicht. Die erfindungsgemäße elektronische Baugruppe verfügt über einen einfachen Aufbau, eine deutlich erhöhte Baudichte/Integration sowie eine Verringerung parasitärer Induktivitäten.

Des weiteren sind die Anschlussbereiche 14.1 und 12.2 als Lastinduktivität L ausgeführt. Die Lastinduktivität L kann beispielsweise durch einen oder mehrere Ferritkerne gebildet sein.

Die erfindungsgemäße Ausgestaltung gestattet darüber hinaus auch einen direkten Kontakt des mindestens einen die Lastinduktivität bildenden Ferritkerns mit der Kühlsenke 60.

Figur 2 zeigt eine alternative Ausgestaltung der elektronischen Baugruppe 50' der Erfindung, das über einen ringförmigen Kondensator C' verfügt, der die Leiterplattenstruktur umgebend angeordnet ist. Die Drain/Source-Anschlussbereiche 12.1, 14.1, 12.2, 14.2 kommen in diesem Fall zu beiden Seiten der Struktur aus der Trägerschicht 12 und der weiteren elektrisch leitenden Schicht 14, so dass insgesamt vier Anschlussbereiche 12.1, 14.1, 12.2, 14.2 vorhanden sind. Grundsätzlich könnte der Ringkondensator mit nur zwei Anschlüssen angeschlossen werden (wie im Ausführungsbeispiel der Figur 1), mit vier Anschlüssen verringert man jedoch wiederum die parasitären Induktivitäten, die in der Schoopierschicht des Ringkondensators auftreten würden auf die Hälfte.

Wie aus der Darstellung der Figur 2 ersichtlich, gestattet die Erfindung mit einem Ringkondensator eine besonders kompakte und flache Bauweise, da die gesamte Innenstruktur einschließlich der Kühlsenke 60 von dem Kondensator umgeben sind. In einer derartigen Anordnung können die erfindungsgemäßen Anschlussbereiche relativ kurz ausgelegt sein. Der Ringkondensator nimmt in seinem Inneren (d.h. der Ringöffnung) den Leiterplattenmehrschichtaufbau auf, aus dem sich die Anschlussbereiche heraus erstrecken. Die Anschlussbereiche sind direkt mit den Anschlüssen des Ringkondensators verbunden. In dem dargestellten Ausführungsbeispiel ist auch die Kühlsenke 60 im Inneren des Ringkondensators angeordnet, um eine möglichst kompakte Bauweise zu erzielen.

Selbstverständlich kann dies auch mit einem rechteckigen Kondensator erzielt werden. Alternativ können zwei getrennte Kondensatorpacken links und rechts an den Anschlusspaaren 12.1, 14.1 und 12.2, 14.2 eingesetzt werden.

In einer konkreten Anwendung kann es sich bei der elektronischen Baugruppe um einen Gleichrichter/Wechselrichter für einen Kfz-Elektromotor handeln. In diesem Fall kann die Baugruppe in besonders platzsparender Weise direkt (mit einer geeigneten thermisch leitfähigen Verbindungsschicht (wie bspw. Haftpasten, Sinterpasten, Lötpasten o.dgl.) dazwischen, um Luftzwischenräume zu vermeiden) auf einem (ohnehin vorhandenen) Kühlabschnitt des Elektromotors platziert werden, so dass dieser die Kühlsenke 60 bildet und keine separate Kühlsenke notwendig ist.

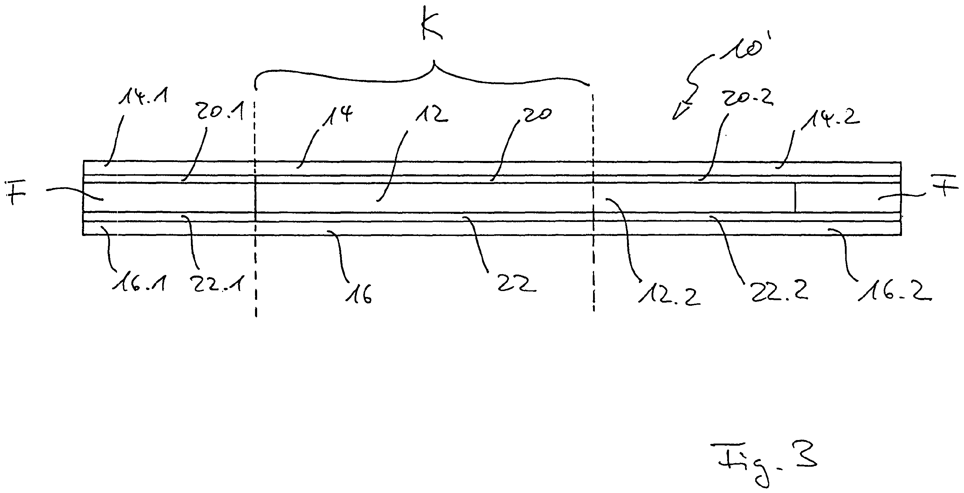

Zur Herstellung einer erfindungsgemäßen elektronischen Baugruppe wird ein an sich bekannter Mehrschichtaufbau 10' bereitgestellt (vgl. Figur 3). Bei diesem Mehrschichtaufbau kann es sich beispielsweise um einen Aufbau handeln, wie er aus der parallelen deutschen Patentanmeldung 10 2010 060 855.6 der gleichen Anmelderin bekannt ist.

Der bereitgestellte Mehrschichtaufbau 10' umfasst eine erste leitende Schicht 12, bei der es sich um eine Trägerschicht für ein nicht dargestelltes Halbleiterbauelement 18 handelt. Des weiteren umfasst der Mehrschichtaufbau 10' eine weitere elektrisch leitende Schicht 14, die in der Darstellung der Figur 3 über der ersten leitenden Schicht 12 liegt. Zwischen den beiden Schichten 12, 14 ist eine Prepreg-Schicht 20 vorgesehen, die aus thermisch leitfähigem Material bestehen kann.

Der Mehrschichtaufbau 10' umfasst außerdem eine zweite weitere elektrisch leitende Schicht 16, die in der Darstellung der Figur 3 unterhalb der ersten leitenden Schicht 12 angeordnet ist und von dieser durch eine zweite Prepreg-Schicht 22 getrennt ist. Auch diese Prepreg-Schicht 22 kann aus thermisch leitfähigem Material bestehen.

Bei den weiteren elektrisch leitenden Schichten 14, 16 kann es sich um Kupferfolien handeln, die zusätzlich plattiert sein können.

Der erfindungsgemäße Leiterplattenmehrschichtaufbau kann einen symmetrischen Aufbau um die Trägerschicht 12 aufweisen, d.h. die Prepreg-Schichten 20, 22 weisen gleiche Dicke auf, ebenso wie die weiteren leitenden Schichten 14, 16 jeweils gleiche Dicke aufweisen. Die Symmetrie des Aufbaus bewirkt eine hohe Zuverlässigkeit der Baugruppe. Während unsymmetrische Aufbauten wie DCB-Substrate unter Temperaturwechselbeanspruchung zur Verbiegung neigen, wird dieses Verhalten bei dem beschriebenen symmetrischen Aufbau unterdrückt.

Die eigentliche Größe/Breite der herzustellenden elektronischen Baugruppe ist in Figur 3 durch die beiden senkrecht verlaufenden gestrichelten Linien angedeutet und wird im folgenden als "Kernbereich" oder Funktionsbereich K bezeichnet. Um die erfindungsgemäß über den Mehrschichtaufbau hinausragenden Schichtabschnitte herzustellen, ragen die Schichten des Mehrschichtaufbaus 10' in diesem Verfahrensabschnitt zu beiden Seiten über die gestrichelten Linien so weit hinaus, wie es der gewünschten Länge der späteren Anschlussbereiche entspricht. Diese Abschnitte der Schichten sind mit den Zusätzen ".1" bzw. ".2" zu den Bezugszeichen gekennzeichnet. Links und rechts (in der Darstellung der Figuren) der Trägerschicht 12 bzw. 12.2 befinden sich freigefräste Innenlagen F.

In den Abschnitten links und rechts der gestrichelten Linien können die Prepreg-Schichten 20.1, 20.2, 22.1, 22.2 aus dem gleichen (thermisch leitfähigen) Material wie im "Kernbereich" K zwischen den gestrichelten Linien oder - wenn sich dies aus Kostengründen anbietet - aus einem billigeren Standardmaterial bestehen. Als Kernbereich K oder auch Funktionsbereich wird derjenige Abschnitt des Leiterplattenmehrschichtaufbaus bezeichnet, der die leistungselektronische und ggf. Ansteuerungs-Funktion beinhaltet. Die über diesen Kernbereich hinausragenden Abschnitte dienen der Verwirklichung des erfindungsgemäßen Gedankens, eine direkte Anschlussmöglichkeit für passive Bauelemente zu schaffen.

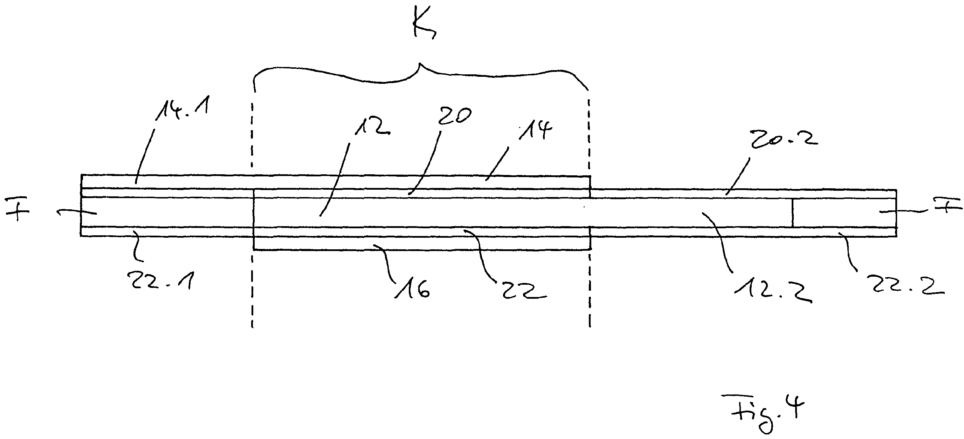

Figur 4 zeigt den Mehrschichtaufbau nach einem Ätzvorgang: die über den Kernbereich ragenden Abschnitte 16.1, 16.2 der zweiten weiteren elektrisch leitenden Schicht 16 wurden weggeätzt, genauso wie einer der beiden hinausragenden Abschnitte 14.2 der ersten weiteren elektrisch leitenden Schicht 14. Die Prepreg-Schichten sind durch den Ätzvorgang unberührt, genauso wie die später noch benötigten hinausragenden Abschnitte 14.1 und 12.2 der ersten weiteren Schicht 14 und der Trägerschicht 12.

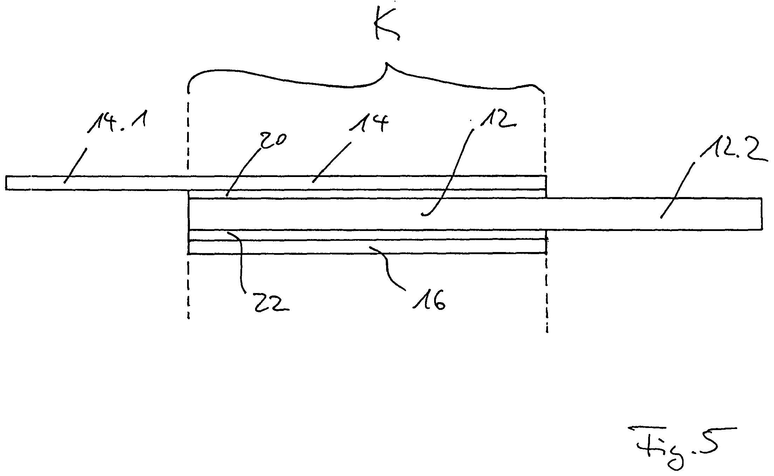

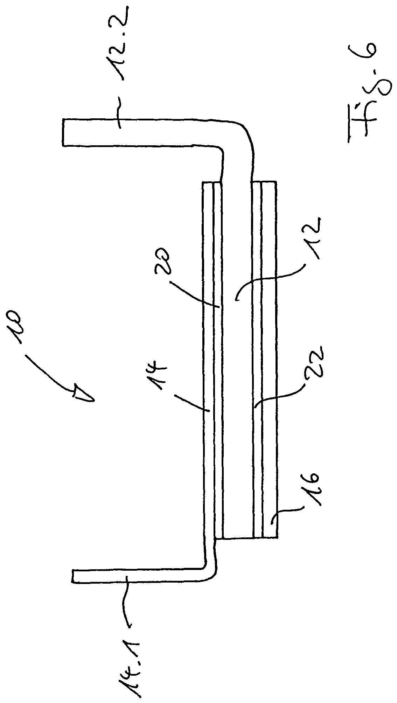

In einem weiteren Schritt werden die freiliegenden Prepreg-Schichten 20.1, 20.2, 22.1 und 22.2 durch Fräsen (Tiefenfräsen) im wesentlichen entfernt (vgl. Figur 5), so dass ein Mehrschichtaufbau 10 zurückbleibt, dessen Schichten im "Kernbereich" den gewünschten Abmessungen entsprechen, wobei zwei der Schichten jeweils einen über den Mehrschichtaufbau 10 hinausragenden Schichtabschnitt 14.1, 12.2 aufweisen. Diese Schichtabschnitte 14.1, 12.2 sind als Anschlussbereiche definiert und werden in einem folgenden Verfahrensschritt ggf. so gebogen, dass sie zur direkten Ankontaktierung eines passiven Bauelements dienen (vgl. Figur 6). Die Anschlussbereiche können erfindungsgemäß laschenartig oder streifenförmig ausgebildet sein. Insbesondere sind die Anschlussbereiche derart ausgebildet, dass sie zur direkten Ankontaktierung mindestens eines zusätzlichen passiven Bauelements geeignet sind, ohne dass zusätzliche Verbindungselemente (wie insbesondere Kabel o.dgl.) notwendig sind.

Die derart gebildeten Anschlussbereiche 14.1, 12.2 können dann mit einem passiven Bauelement, im vorliegenden Ausführungsbeispiel einem Kondensator C, C', verbunden werden, bspw. durch Verlöten, ggf. über eine Schoopierschicht.

Des weiteren können einer oder beide der Anschlussbereiche 14.1, 12.2 als mindestens eine Lastinduktivität L ausgebildet werden, indem der leitfähige Anschlussbereich mit z.B. Ferritkernen umschlossen wird. Des weiteren kann die Struktur mit einer Kühlsenke 60 verbunden werden. Das Endprodukt kann vergossen werden (Verguss 70; vgl. Figur 1).

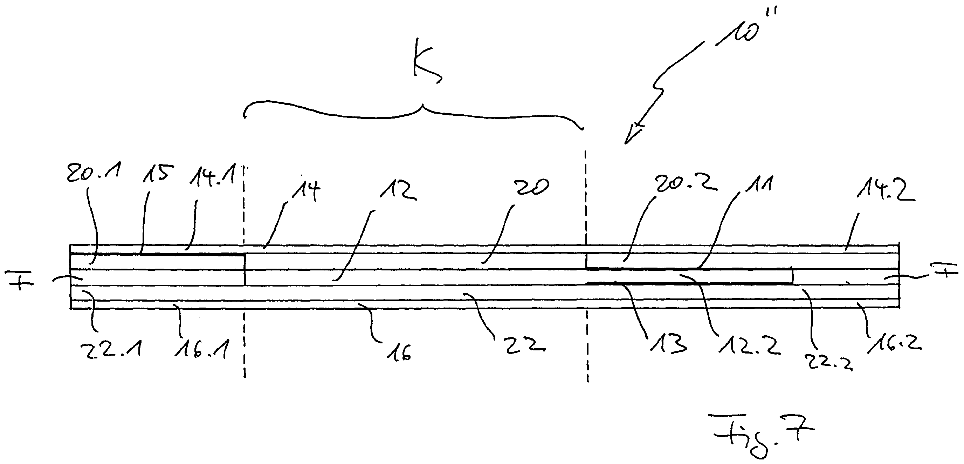

Eine Variante für den Ausgangs-Mehrschichtaufbau 10" ist in Figur 7 dargestellt. Der grundsätzliche Aufbau der Mehrschichtstruktur entspricht der Darstellung der Figur 3, mit dem Unterschied, dass zwischen den hinausragenden Schichtabschnitten 14.1 und 12.2 und ihren angrenzenden Prepreg-Schichtabschnitten 20.1, 20.2, 22.2 Trennfolien 11, 13, 15 vorgesehen sind, die ein Entfernen der Prepreg-Schichtabschnitte 20.1, 20.2, 22.2 von den späteren Anschlussbereichen 14.1, 12.2 auf mechanischem Wege durch Abziehen, Abschälen o.dgl. ermöglichen bzw. erleichtern. Hierzu wird die Kontur des abzuziehenden Bereichs tiefengefräst, um Zugang zu der Trennfolie zu erhalten. Der Vorteil besteht darin, dass nur die Kontur und nicht die gesamte Fläche gefräst, geätzt bzw. gelasert werden muss. Anstatt der dargestellten und beschriebenen Trennfolie (bei der es sich bspw. um eine Teflonfolie oder teflonartige Folie handeln kann) kann jedes andere Trennmittel verwendet werden, das ein Verkleben der Prepreg-Schicht mit der elektrisch leitenden Schicht verhindert. Bei dem Trennmittel kann es sich auch um ein geeignetes flüssiges oder pastenförmiges Material handeln, das mittels Siebdruck, Sprühen oder Eintauchen aufgebracht wird.

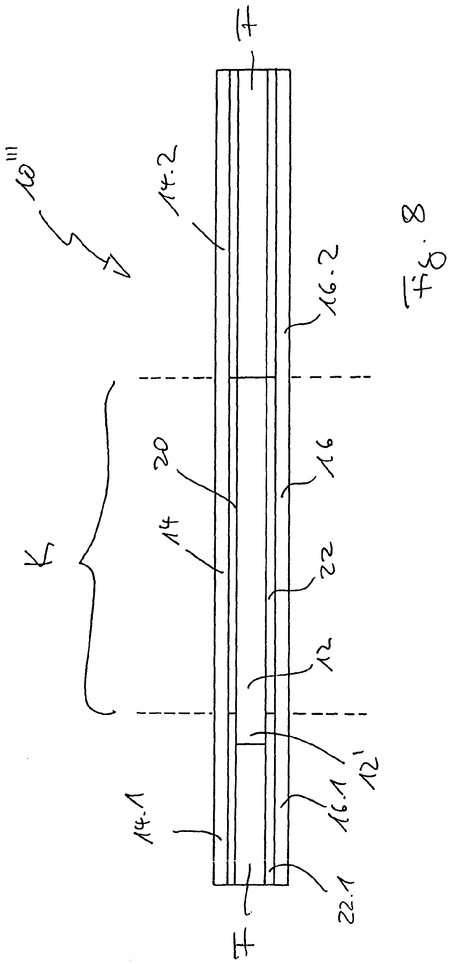

Eine weitere Variante, wie sie in Figur 8 dargestellt ist, sieht einen sogenannten Ebenenversatz vor.

In dieser Ausführungsvariante wird ein Mehrschichtaufbau 10"' vorgesehen, bei dem die Trägerschicht 12 nur wenig über den "Kernbereich" hinaus verlängert ist (Bezugszeichen 12'). Die weitere elektrisch leitende Schicht 14 ist - wie in den Ausführungsbeispielen zuvor - auf beiden Seiten über den Kernbereich hinaus verlängert (Bezugszeichen 14.1 und 14.2).

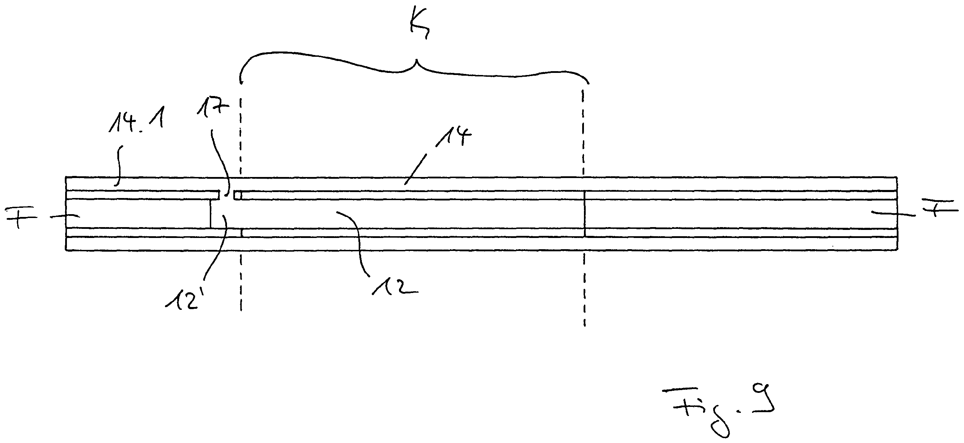

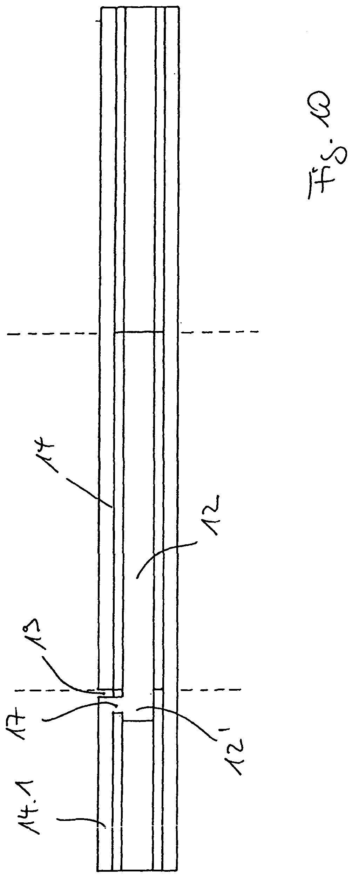

In einem nächsten Schritt erfolgt eine Durchkontaktierung 17 (bei der es sich auch um mehrere Durchkontaktierungen bspw. in Form einer oder mehrerer Durchkontaktierungsreihen handeln kann) von dem verlängerten Schichtabschnitt 14.1 der ersten weiteren elektrisch leitenden Schicht 14 zu dem darunterliegenden kurzen Vorsprung 12' der Trägerschicht 12 (vgl. Figur 9), und darauf folgend eine Trennung des Schichtabschnitts 14.1 von der ersten weiteren elektrisch leitenden Schicht 14 an der Grenze des "Kernbereichs" und vor der Durchkontaktierung 17 (vgl. Figur 10, Bezugszeichen 19). Auf diese Art und Weise wird eine Verbindung zwischen der (etwas dickeren) Trägerschicht 12 und dem (dünneren) Anschlussbereich 14.1 der ersten weiteren elektrisch leitenden Schicht 14 geschaffen, so dass die Trägerschicht 12 über einen dünneren "Hilfs"-Anschlussbereich verfügt. Die Folge ist, dass die Anschlussbereiche beide i)auf einer Ebene liegen und ii) die gleiche Dicke aufweisen.

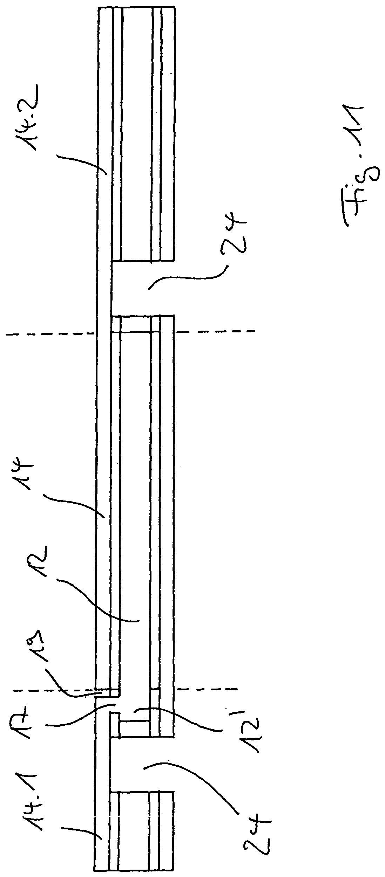

Daraufhin folgen Tiefenfräsungen von der der ersten weiteren elektrisch leitenden Schicht 14 gegenüber liegenden Seite, also von der Seite der zweiten elektrisch leitenden Schicht 16 her, um zu jeder Seite des Kernbereichs jeweils einen Biegebereich 24 auszubilden. Die Tiefenfräsungen werden außerhalb des Kernbereichs, aber in dessen Nähe durchgeführt, so dass ein Biegen der Anschlussbereiche möglichst nahe am Kernbereich erfolgen kann. Die Tiefenfräsungen gehen durch alle Schichten bis auf die Anschlussbereiche 14.1 und 14.2 (vgl. Figur 11).

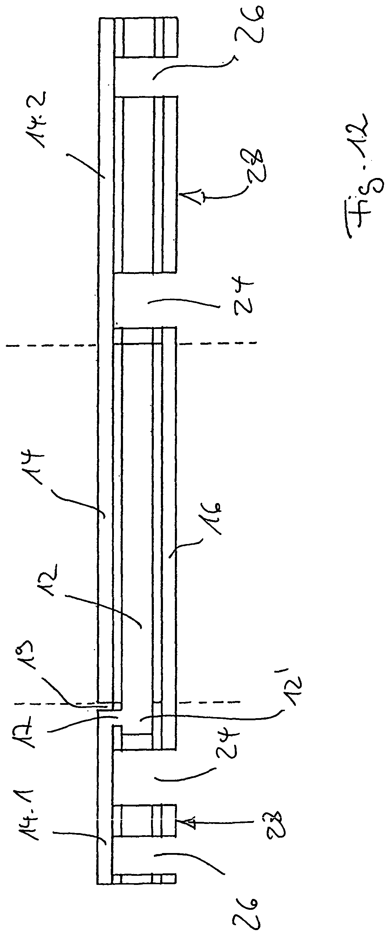

Schließlich können zweite Tiefenfräsungen, gleichfalls von der der ersten weiteren elektrisch leitenden Schicht 14 gegenüber liegenden Seite, also von der Seite der zweiten elektrisch leitenden Schicht 16 her, vorgenommen werden. Die zweiten Tiefenfräsungen dienen zur Erzeugung von Lötanschlüssen 26, um das passive Bauelement anschließen zu können (vgl. Figur 12). Die verbleibenden Bereiche 28 mit Schichtabfolgen unterhalb der Anschlussbereiche 14.1 und 14.2 können als Abstandhalter zu einem die elektronische Baugruppe umgebenden (nicht dargestellten) Gehäuse beim Vergießen dienen.

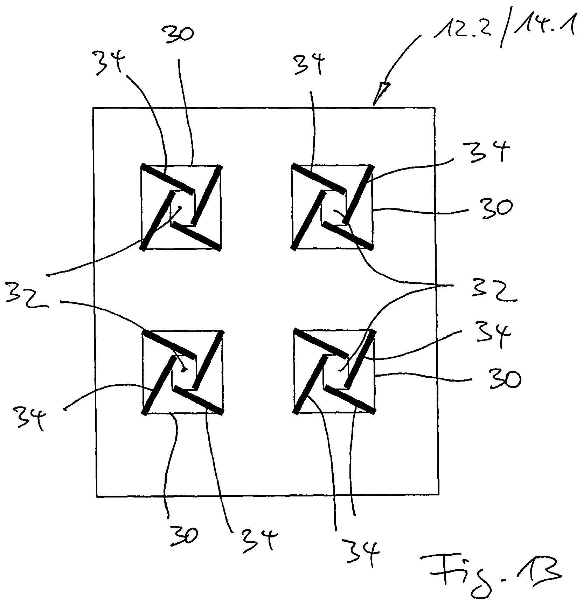

Figur 13 zeigt einen Ausschnitt einer Draufsicht auf eine Ausgestaltung eines erfindungsgemäßen Anschlussbereiches 12.2 bzw. 14.1. Der Anschlussbereich weist eine oder (wie dargestellt) mehrere Ausnehmungen 30 auf (im Ausführungsbeispiel der Figur 13 sind vier Ausnehmungen dargestellt). In jeder Ausnehmung 30 ist eine Kontaktierungsfläche 32 vorgesehen, die zum Anschweißen oder Anlöten an einen Kontakt des anzuschließenden passiven Bauelements vorgesehen und ausgebildet ist. Im dargestellten Ausführungsbeispiel weist die Kontaktierungsfläche 32 einen im wesentlichen rechteckigen Grundriss auf, sie kann aber auch jede andere beliebige und geeignete Form aufweisen.

Die Kontaktierungsfläche 32 ist mittels mindestens eines Haltesteges 34 elektrisch mit dem Anschlussbereich verbunden. In dem dargestellten Ausführungsbeispiel sind je Kontaktierungsfläche 32 vier Haltestege 34 vorgesehen; es können jedoch auch mehr oder weniger sein. Die Haltestege 34 weisen einen geringeren thermischen Querschnitt als die Anschlussbereichumgebung auf, so dass der Anschweiß- bzw. Anlötvorgang vereinfacht ist.

Des weiteren sind die Haltestege 34 so ausgeführt, dass sie unterschiedliche Ausdehnungskoeffizienten beim Betrieb (der mit Erwärmung verbunden ist) ausgleichen. Die erfolgt dadurch, dass die Haltestege 34 dazu geeignet sind, eine mechanische Spannungs- bzw. Zugentlastung aufzunehmen. In der dargestellten Ausführungsform ist die geometrische Anordnung derart, dass bei geraden Haltestegen 34 eine Verdrehung der Kontaktierungsfläche 32 möglich ist. Dies wird durch eine gebrochene Symmetrie bei der Verbindung der Kontaktierungsfläche mit dem Anschlussbereich erreicht. Eine andere (nicht dargestellte) Möglichkeit besteht z.B. darin, den oder die Haltestege mäanderförmig oder zickzackförmig o.dgl. auszubilden.

Die Erfindung ermöglicht somit ein direktes Anschließen eines passiven Bauelements an einer Leiterplattenmehrschichtstruktur, ohne zusätzliche Verbindungsmittel, Leitungen, Bonddrähte o.dgl. Lediglich das Verbinden (in der Regel Anlöten) des Bauelements muss noch vorgenommen werden. Damit werden die Kontaktierungswege verkürzt, die Zahl der Lötverbindungen und damit auch die Zuverlässigkeit gesteigert, die parasitären Induktivitäten verringert und die Integrationsdichte erhöht.

## Patentansprüche

1. Elektronische Baugruppe (50, 50') mit einer Leiterplattenstruktur, die einen Mehrschichtaufbau (10) umfasst, der mindestens eine elektrisch leitende Trägerschicht (12) mit einem Halbleiterbauelement (18) und mindestens eine weitere elektrisch leitende und mit dem Halbleiterbauelement (18) verbundene Schicht (14) aufweist, und mit einem passiven Bauelement (C, C'; L), das mit den beiden elektrisch leitenden Schichten (12, 14) verbunden ist, wobei die zwei elektrisch leitenden Schichten (12, 14) jeweils mindestens einen über einen Kernbereich (K) des Mehrschichtaufbaus (10) hinaus verlängerten Abschnitt mit daran ausgebildeten Anschlussbereichen (12.2, 14.1, 14.2) aufweisen, der durch zumindest teilweises Entfernen von über den Kernbereich (K) hinausragenden Schichtabschnitten (16.1, 16.2, 14.2), die nicht als Anschlussbereich benötigt werden, und durch zumindest teilweises Entfernen von über den Kernbereich (K) hinausragenden Prepreg-Schichtabschnitten (20.1, 20.2, 22.1, 22.2) gebildet ist, und wobei das passive Bauelement (C, C'; L) direkt an den Anschlussbereichen (12.2, 14.1, 14.2) ankontaktiert ist.

2. Elektronische Baugruppe (50, 50') nach Anspruch 1, bei der das zusätzliche passive Bauelement ein Kondensator (C, C') und/oder eine Induktivität (L) ist.

3. Elektronische Baugruppe (50, 50') nach Anspruch 2, bei der der Kondensator ein den Leiterplattenmehrschichtaufbau umgebender Ringkondensator (C') ist, und/oder
bei der eine direkt mit den Anschlussbereichen (12.1, 12.2, 14.1, 14.2) verbundene Lastinduktivität (L) vorgesehen ist.

4. Elektronische Baugruppe (50, 50') nach einem der voranstehenden Ansprüche, bei der der Leiterplattenmehrschichtaufbau mit einer Kühlsenke (60) verbunden ist, und/ oder
bei der eine direkt mit den Anschlussbereichen (12.1, 12.2, 14.1, 14.2) verbundene Lastinduktivität (L) direkt mit einer Kühlsenke (60) verbunden ist, und/oder
die in einem Vergussmantel (70) aufgenommen bzw. vergossen ist.

5. Elektronische Baugruppe nach einem der Ansprüche 1 bis 4, bei der mindestens einer der Anschlussbereiche (12.2, 14.1, 14.2) mindestens eine Ausnehmung (30) mit einer darin enthaltenen Kontaktierungsfläche (32) zum Ankontaktieren eines passiven Bauelements aufweist.

6. Elektronische Baugruppe nach Anspruch 5, bei der die Kontaktierungsfläche (32) zum direkten Ankontaktieren an die Schoopierschicht eines Folienkondensators ausgebildet ist, und/oder
bei der die Kontaktierungsfläche (32) mittels mindestens eines Haltesteges (34) elektrisch mit dem Anschlussbereich verbunden ist, und/oder
bei der die Kontaktierungsfläche (32) mittels mindestens eines Haltesteges (34) elektrisch mit dem Anschlussbereich verbunden ist und der Haltesteg (34) zur Aufnahme unterschiedlicher Ausdehnungskoeffizienten beim Betrieb ausgebildet ist.

7. Elektromotor mit einer als Gleichrichter-/Wechselrichtersystem ausgebildeten elektronischen Baugruppe (50, 50') nach einem der voranstehenden Ansprüche, wobei zur Bildung einer Kühlsenke (60) der Leiterplattenmehrschichtaufbau direkt auf einem Kühlbereich des Elektromotors angebracht ist.

8. Verfahren zur Herstellung einer elektronischen Baugruppe (50, 50') gemäß einem der Ansprüche 1 bis 6, mit den folgenden Schritten:
- Bereitstellen eines Mehrschichtaufbaus (10'; 10"; 10"') mit einer elektrisch leitenden Trägerschicht (12) und mindestens einer weiteren elektrisch leitenden Schicht (14), die über einen Kernbereich (K) des Mehrschichtaufbaus hinausragende Schichtabschnitte (12', 12.2, 14.1, 14.2) aufweisen,
- zumindest teilweises Entfernen von über den Kernbereich (K) hinausragenden Schichtabschnitten (16.1, 16.2, 14.2), die nicht als Anschlussbereich benötigt werden,
- zumindest teilweises Entfernen von über den Kernbereich (K) hinausragenden Prepreg-Schichtabschnitten (20.1, 20.2, 22.1, 22.2),
- Ausbilden von Anschlussbereichen (14.1, 12.2; 14.2) an den über den Kernbereich (K) hinausragenden verbliebenen Schichtabschnitten, und
- direktes Ankontaktieren eines passiven Bauelements (C, C'; L) an die Anschlussbereiche (14.1, 12.2; 14.2).

9. Verfahren nach Anspruch 8, bei dem der Schritt des Ausbildens der Anschlussbereiche (14.1, 12.2; 14.2) den Schritt des Biegens der über den Kernbereich (K) hinausragenden verbliebenen Schichtabschnitte umfasst.

10. Verfahren nach Anspruch 8, bei dem vor dem Schritt des zumindest teilweisen Entfernens der über den Kernbereich (K) hinausragenden Schichtabschnitte (16.1, 16.2, 14.2), die nicht als Anschlussbereich benötigt werden, folgende Schritte durchgeführt werden:
- Herstellen einer Durchkontaktierung (17) zwischen einem hinausragenden Schichtabschnitt (14.1) der weiteren elektrisch leitenden Schicht (14) und einem hinausragenden Schichtabschnitt (12') der Trägerschicht (12),
- Trennen des hinausragenden Schichtabschnitts (14.1) der weiteren elektrisch leitenden Schicht (14) von der weiteren elektrisch leitenden Schicht (14).

11. Verfahren nach einem der Ansprüche 8 bis 10, bei dem die beiden Schritte des teilweisen Entfernens folgendermaßen durchgeführt werden:
- Ausbilden eines Biegebereichs (24) in zu jeder Seite des Kernbereichs (K) durch begrenztes Entfernen aller Schichten bis auf die Anschlussbereiche (14.1, 14.2) durch Tiefenfräsen.

12. Verfahren nach einem der Ansprüche 8 bis 11, bei dem nach den Schritten des teilweisen Entfernens verbliebene Bereiche (28) mit Schichtabfolgen unterhalb der Anschlussbereiche (14.1, 14.2, 12.2) als Abstandhalter (28) zu einem die elektronische Baugruppe umgebenden Gehäuse dienen.

13. Verfahren nach Anspruch 8, bei dem zwischen den hinausragenden Schichtabschnitten (14.1 und 12.2) und ihren angrenzenden Prepreg-Schichtabschnitten (20.1, 20.2, 22.2) Trennmittel (11, 13, 15) zum mechanischen Entfernen der Prepreg-Schichtabschnitte (20.1, 20.2, 22.2) von den späteren Anschlussbereichen (14.1, 12.2) vorgesehen sind.

14. Verfahren nach Anspruch 8, bei dem das Entfernen der Schichtabschnitte (16.1, 16.2, 14.2), die nicht als Anschlussbereich benötigt werden, durch Ätzen erfolgt und das Entfernen von über den Kernbereich (K) hinausragenden Prepreg-Schichtabschnitten (20.1, 20.2, 22.1, 22.2) durch Fräsen erfolgt.

15. Verfahren nach Anspruch 8 oder 14, bei dem das Entfernen von über den Kernbereich (K) hinausragenden Schichtabschnitten (16.1, 16.2, 14.2), die nicht als Anschlussbereich benötigt werden, und das Entfernen von über den Kernbereich (K) hinausragenden Prepreg-Schichtabschnitten (20.1, 20.2, 22.1, 22.2) im wesentlichen vollständig erfolgt.

## Claims

1. Electronic assembly (50, 50') with a printed circuit board structure, which comprises a multilayer structure (10) that has at least one electrically conductive carrier layer (12) with a semiconductor component (18) and at least one further electrically conductive layer (14) connected to the semiconductor component (18), and with a passive component (C, C'; L), which is connected to the two electrically conductive layers (12, 14), the two electrically conductive layers (12, 14) respectively having at least one portion that is made to extend beyond a core region (K) of the multilayer structure (10) with connection regions (12.2, 14.1, 14.2) formed on it, which is formed by at least partially removing layer portions (16.1, 16.2, 14.2) that protrude beyond the core region (K) and are not required as a connection region, and by at least partially removing prepreg layer portions (20.1, 20.2, 22.1, 22.2) that protrude beyond the core region (K), and the passive component (C, C'; L) making contact directly at the connection regions (12.2, 14.1, 14.2).

2. Electronic assembly (50, 50') according to Claim 1, in which the additional passive component is a capacitor (C, C') and/or an inductor (L).

3. Electronic assembly (50, 50') according to Claim 2, in which the capacitor is an annular capacitor (C') surrounding the multilayer printed circuit board structure, and/or
in which a load inductor (L) directly connected to the connection regions (12.1, 12.2, 14.1, 14.2) is provided.

4. Electronic assembly (50, 50') according to one of the preceding claims, in which the printed circuit board multi-layer structure is connected to a heat sink (60), and/or
in which the load inductor (L) directly connected to the connection regions (12.1, 12.2, 14.1, 14.2) is directly connected to a heat sink (60), and/or
which is mounted or potted in a casting jacket (70).

5. Electronic assembly according to one of Claims 1 to 4, in which at least one of the connection regions (12.2, 14.1, 14.2) has at least one recess (30) with a contact pad (32) contained therein for making contact with a passive component.

6. Electronic assembly according to Claim 5, in which the contact pad (32) is designed to make direct contact with the Schoop layer of a foil capacitor, and/or
in which the contact pad (32) is electrically connected to the connection region by means of at least one holding web (34), and/or
in which the contact pad (32) is electrically connected to the connection region by means of at least one holding web (34) and the holding web (34) is designed so as to compensate for different coefficients of expansion during operation.

7. Electric motor with an electronic assembly (50, 50') according to one of the preceding claims designed as a rectifier/inverter, wherein in order to form a heat sink (60) the multilayer printed circuit board structure is directly mounted on a cooling region of the electric motor.

8. Method for producing an electronic assembly (50, 50') according to one of Claims 1 to 6, with the following steps:
- providing a multilayer structure (10'; 10"; 10"') having an electrically conductive carrier layer (12) and at least one further electrically conductive layer (14), which have layer portions (12', 12.2, 14.1, 14.2) that protrude beyond a core region (K) of the multilayer structure,
- at least partially removing layer portions (16.1, 16.2, 14.2) that protrude beyond the core region (K) and are not required as a connection region,
- at least partially removing prepreg layer portions (20.1, 20.2, 22.1, 22.2) that protrude beyond the core region (K),
- forming connection regions (14.1, 12.2; 14.2) on the remaining layer portions that protrude beyond the core region (K), and
- making direct contact between a passive element (C, C'; L) and the connection regions (14.1, 12.2; 14.2).

9. Method according to Claim 8, in which the step of forming the connection regions (14.1, 12.2; 14.2) comprises the step of bending the remaining layer portions that protrude beyond the core region (K).

10. Method according to Claim 8, in which, before the step of at least partially removing the layer portions (16.1, 16.2, 14.2) that protrude beyond the core region (K) and are not required as a connection region, the following steps are carried out:
- producing a through-contact (17) between a protruding layer portion (14.1) of the further electrically conductive layer (14) and a protruding layer portion (12') of the carrier layer (12),
- separating the protruding layer portion (14.1) of the further electrically conductive layer (14) from the further electrically conductive layer (14).

11. Method according to one of Claims 8 to 10, in which the two partial removal steps are carried out as follows:
- forming a bending region (24) on either side of the core region (K) by limited removal of all the layers apart from the connection regions (14.1, 14.2) by means of deep milling.

12. Method according to one of Claims 8 to 11, in which, after the partial removal steps, remaining regions (28) with layer sequences below the connection regions (14.1, 14.2, 12.2) act as spacers (28) with respect to a housing surrounding the electronic assembly.

13. Method according to Claim 8, in which separating means (11, 13, 15) for mechanically removing the prepreg layer portions (20.1, 20.2, 22.2) from the later connection regions (14.1, 12.2) are provided between the protruding layer portions (14.1 and 12.2) and their adjacent prepreg layer portions (20.1, 20.2, 22.2).

14. Method according to Claim 8, in which the removal of the layer portions (16.1, 16.2, 14.2) that are not required as a connection region is performed by etching, and the removal of prepreg layer portions (20.1, 20.2, 22.1, 22.2) that protrude beyond the core region (K) is performed by milling.

15. Method according to Claim 8 or 14, in which the re-moval of layer portions (16.1, 16.2, 14.2) that protrude beyond the core region (K) and are not required as a connection region and the removal of prepreg layer portions (20.1, 20.2, 22.1, 22.2) that protrude beyond the core region (K) is performed substantially completely.

## Revendications

1. Ensemble structurel électronique (50, 50') comprenant une structure de carte à circuits imprimés qui présente une structure multicouche (10) qui comporte au moins une couche porteuse (12) électriquement conductrice pourvue d'un élément semi-conducteur (18) et au moins une autre couche (14) électriquement conductrice reliée à l'élément semi-conducteur (18), et comprenant un composant passif (C, C' ; L) qui est relié aux deux couches (12, 14) électriquement conductrices, dans lequel les deux couches (12, 14) électriquement conductrices présentent chacune au moins une portion prolongée au-delà d'une zone de coeur (K) de la structure multicouche (10) et pourvue de zones de raccordement (12.2, 14.1, 14.2) réalisées sur ladite portion, laquelle est réalisée par enlèvement au moins partiel de portions de couche (16.1, 16.2, 14.2) qui dépassent au-delà de la zone de coeur (K) et qui ne sont pas nécessaires en tant que zone de raccordement, et par enlèvement au moins partiel de portions de couche préimprégnées (20.1, 20.2, 22.1, 22.2) qui dépassent au-delà de la zone de coeur (K), et dans lequel le composant passif (C, C' ; L) est directement mis en contact avec les zones de raccordement (12.2, 14.1, 14.2).

2. Ensemble structurel électronique (50, 50') selon la revendication 1, dans lequel le composant passif supplémentaire est un condensateur (C, C') et/ou une inductance (L).

3. Ensemble structurel électronique (50, 50') selon la revendication 2, dans lequel le condensateur est un condensateur annulaire (C') entourant la structure multicouche de la carte à circuits imprimés, et/ou dans lequel est prévue une inductance de charge (L) connectée directement aux zones de raccordement (12.1, 12.2, 14.1, 14.2).

4. Ensemble structurel électronique (50, 50') selon l'une des revendications précédentes, dans lequel la structure multicouche de la carte à circuits imprimés est pourvue d'un puits de refroidissement (60) et/ou
dans lequel une inductance de charge (L) connectée directement aux zones de raccordement (12.1, 12.2, 14.1, 14.2) est reliée directement à un puits de refroidissement (60), et/ou
qui est reçu ou surmoulé dans une enveloppe de coulée (70).

5. Ensemble structurel électronique selon l'une des revendications 1 à 4, dans lequel l'une au moins des zones de raccordement (12.2, 14.1, 14.2) présente au moins un évidement (30) pourvu d'une surface de mise en contact (32) comprise dans ce dernier et destinée à mettre en contact un composant passif.

6. Ensemble structurel électronique selon la revendication 5, dans lequel la surface de contact (32) est réalisée pour la mise en contact direct avec la couche pulvérisée finale d'un condensateur en film et/ou
dans lequel la surface de mise en contact (32) est électriquement connectée à la zone de raccordement au moyen d'au moins une barrette de retenue (34), et/ou
dans lequel la surface de mise en contact (32) est électriquement connectée à la zone de raccordement au moyen d'au moins une barrette de retenue (34), et la barrette de retenue (34) est réalisée pour encaisser différents coefficients de dilatation pendant le fonctionnement.

7. Moteur électrique comportant un ensemble structurel électronique (50, 50'), réalisé sous forme de système à redresseur/onduleur, selon l'une des revendications précédentes, dans lequel
en vue de réaliser un puits de refroidissement (60), la structure multicouche de la carte à circuits imprimés est montée directement sur une zone de refroidissement du moteur électrique.

8. Procédé de réalisation d'un ensemble structurel électronique (50, 50') selon l'une des revendications 1 à 6, comprenant les étapes suivantes :
- on fournit une structure multicouche (10' ; 10" ; 10"') pourvue d'une couche porteuse (12) électriquement conductrice et d'au moins une autre couche (14) électriquement conductrice, qui comprennent des portions de couche (12', 12.2, 14.1, 14.2) qui s'étendent au-delà d'une zone de coeur (K) de la structure multicouche,
- on enlève au moins partiellement des portions de couche (16.1, 16.2, 14.2) qui dépassent au-delà de la zone de coeur (K) et qui ne sont pas nécessaires en tant que zone de raccordement,
- on enlève au moins partiellement des portions de couche préimprégnées (20.1, 20.2, 22.1, 22.2) qui dépassent au-delà de la zone de coeur (K),
- on réalise des zones de raccordement (14.1, 12.2 ; 14.2) sur des portions de couche restantes dépassant au-delà de la zone de coeur (K), et
- on met en contact direct un composant passif (C, C' ; L) avec les zones de raccordement (14.1, 12.2 ; 14.2).

9. Procédé selon la revendication 8, dans lequel l'étape de la réalisation des zones de raccordement (14.1, 12.2 ; 14.2) comprend l'étape consistant à cintrer des portions de couche restantes dépassant au-delà de la zone de coeur (K).

10. Procédé selon la revendication 8, dans lequel, avant l'étape d'enlèvement au moins partiel de portions de couche (16.1, 16.2, 14.2) qui dépassent au-delà de la zone de coeur (K) et qui ne sont pas nécessaires en tant que zone de raccordement, on met en oeuvre les étapes suivantes :
- on réalise un contact traversant (17) entre une portion de couche dépassante (14.1) de l'autre couche électriquement conductrice (14) et une portion de couche dépassante (12') de la couche porteuse (12),
- on sépare de l'autre couche électriquement conductrice (14) la portion de couche dépassante (14.1) de l'autre couche électriquement conductrice (14).

11. Procédé selon l'une des revendications 8 à 10, dans lequel on met en oeuvre les deux étapes d'enlèvement partiel de la manière suivante :
- on réalise une zone de cintrage (24) vers chaque côté de la zone de coeur (K) par enlèvement limité de toutes les couches, exception faite des zones de raccordement (14.1, 14.2), par fraisage profond.

12. Procédé selon l'une des revendications 8 à 11, dans lequel des zones (28) qui restent après les étapes d'enlèvement partiel et qui présentent des successions de couches au-dessous des zones de raccordement (14.1, 14.2, 12.2) servent d'éléments écarteurs (28) par rapport à un boîtier entourant l'ensemble structurel électronique.

13. Procédé selon la revendication 8, dans lequel on prévoit des moyens de séparation (11, 13, 15) entre les portions de couche dépassantes (14.1 et 12.2) et leurs portions de couche préimprégnées adjacentes (20.1, 20.2, 22.2) pour enlever mécaniquement les portions de couche préimprégnées (20.1, 20.1, 22.2) des zones de raccordement ultérieures (14.1, 12.2).

14. Procédé selon la revendication 8, dans lequel l'enlèvement des portions de couche (16.1, 16.2, 14.2) qui ne sont pas nécessaires en tant que zone de raccordement s'effectue par gravure, et l'enlèvement des portions de couche préimprégnées (20.1, 20.2, 22.1, 22.2) dépassant au-delà de la zone de coeur (K) s'effectue par fraisage.

15. Procédé selon la revendication 8 ou 14, dans lequel l'enlèvement des portions de couche (16.1, 16.2, 14.2) qui dépassent au-delà de la zone de coeur (K) et qui ne sont pas nécessaires en tant que zone de raccordement, et l'enlèvement des portions de couche préimprégnées (20.1, 20.2, 22.1, 22.2) qui dépassent au-delà de la zone de coeur (K) s'effectuent sensiblement complètement.
